# FASCICULE DE BREVET EUROPEEN

(11) **EP 2 725 711 B1**
(45) Date de publication et mention de la délivrance du brevet: **20.05.2020**
(21) Numéro de dépôt: 12190221.7
(22) Date de dépôt: 26.10.2012
(51) Int. Cl.: H03G 3/30, H03H 11/24

(54) **Circuit électronique à unité d'atténuation d'au moins un signal d'entrée d'un amplificateur dans une boucle de commande automatique du gain**
Elektronischer Schaltkreis mit einer Abschwächungseinheit für mindestens ein Eingangssignal eines Verstärkers in einem automatischen Regelkreis der Verstärkung
Electronic circuit with unit for attenuating at least one input signal of an amplifier in an automatic gain control loop

(43) Date de publication de la demande: 30.04.2014
(73) Titulaire: EM Microelectronic-Marin SA, 2074 Marin (CH)
(72) Inventeur: Tajalli, Armin, 1022 Chavannes-près-Renens (CH)
(74) Mandataire: Ravenel, Thierry Gérard Louis

(56) Documents cités:
- WO-A1-2011/080536
- US-A- 4 471 311
- US-A- 4 839 611
- US-A- 5 699 017
- US-A1- 2009 201 091

## Description

### DOMAINE TECHNIQUE

La présente invention concerne un circuit électronique muni d'une unité d'atténuation d'au moins un signal d'entrée d'un amplificateur d'entrée dans une boucle de commande automatique du gain. Le circuit électronique comprend en plus de l'amplificateur d'entrée, également une unité de commande automatique du gain, qui fournit un signal d'adaptation à l'unité d'atténuation en fonction du niveau d'amplification détecté. L'unité d'atténuation est ainsi en mesure d'atténuer l'amplitude d'au moins un signal d'entrée sur la base du signal d'adaptation relatif au niveau détecté d'amplitude en sortie de l'amplificateur d'entrée.

### ARRIERE-PLAN TECHNOLOGIQUE

De manière conventionnelle, un circuit électronique à boucle de commande automatique du gain d'un amplificateur d'entrée peut être prévu dans un récepteur de signaux radiofréquences de données ou de commande ou dans tout autre type de récepteur ou transmetteur de données. Lors de la réception de signaux de données à une fréquence porteuse déterminée, ces signaux sont captés par une antenne et mis en forme dans un étage conventionnel de mise en forme. Ces signaux mis en forme sont fournis à un amplificateur d'entrée du circuit électronique.

Normalement la sortie de cet amplificateur d'entrée peut être reliée à un bloc mélangeur ou parfois directement à un bloc démodulateur ou à un convertisseur analogique-numérique. Ce bloc mélangeur permet de convertir la fréquence des signaux captés par l'antenne et amplifiés par l'amplificateur d'entrée au moyen d'au moins un signal oscillant d'un oscillateur local. Le ou les signaux intermédiaires fournis en sortie du bloc mélangeur peuvent ainsi être convertis à une basse fréquence, et même directement en bande de base avant une opération de démodulation des données ou commande dans un démodulateur. Pour pouvoir démoduler correctement les données des signaux intermédiaires, il est nécessaire d'adapter l'amplitude des signaux amplifiés par l'amplificateur d'entrée dans la boucle de commande automatique du gain du circuit électronique. L'adaptation d'amplitude tient compte également du fait que l'amplificateur d'entrée doit être en mesure d'opérer dans un mode de fonctionnement linéaire.

L'amplitude de ces signaux fournis à l'amplificateur d'entrée peut être trop grande, ce qui génère une marge importante de variation des signaux d'entrée. Dans ces conditions, l'amplificateur d'entrée, qui peut être un amplificateur du type VGA ou LNA, peut devenir non linéaire, ce qui n'est pas souhaitable pour un bon fonctionnement du circuit électronique. Il peut donc être prévu de placer une résistance variable de dérivation aux entrées de l'amplificateur d'entrée pour atténuer facilement l'amplitude des signaux d'entrées. Ceci permet d'avoir un fonctionnement linéaire de l'amplificateur. La valeur résistive de la résistance variable peut être contrôlée dans une boucle de commande automatique du gain du circuit électronique, qui dépend du niveau d'amplitude en sortie de l'amplificateur d'entrée comparé à un niveau de référence d'amplitude souhaité.

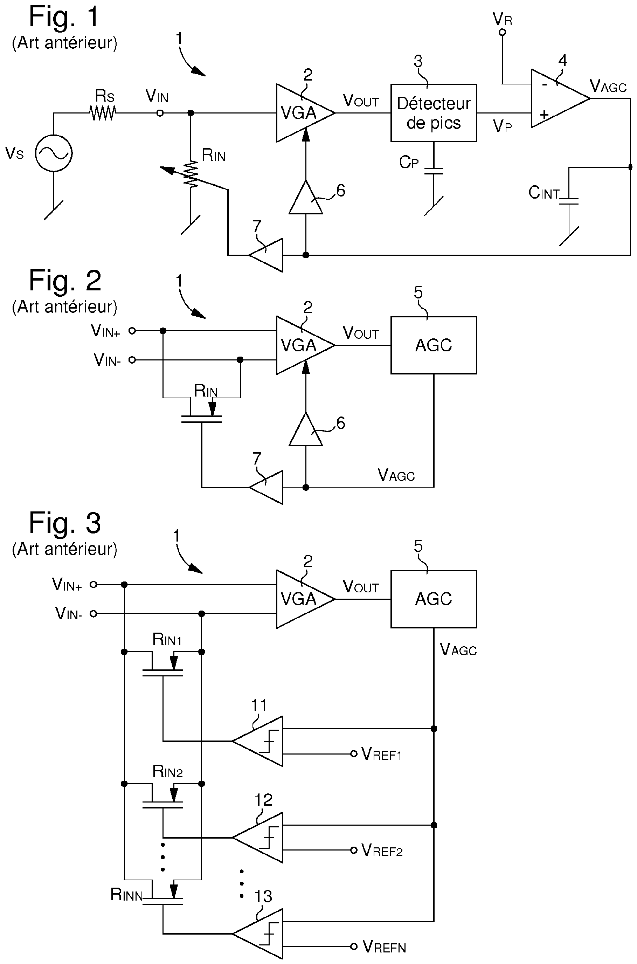

A la figure 1, il est représenté un tel circuit électronique 1 conventionnel, qui est muni de moyens d'atténuation d'au moins un signal d'entrée V_{IN} d'un amplificateur d'entrée 2. Dans cet exemple de l'état de la technique, il est représenté une tension sinusoïdale V_{S} pour fournir au moins un signal d'entrée V_{IN} à travers une résistance série R_{S} à l'amplificateur d'entrée 2. Cependant, il est bien clair que le ou les signaux d'entrée proviennent de préférence de signaux captés par une antenne non représentée.

Le gain de l'amplificateur d'entrée 2, qui peut être un amplificateur du type VGA, peut être ajusté dans une boucle de commande automatique du gain de deux manières. Le gain de l'amplificateur 2 peut ainsi être ajusté en changeant le propre gain de l'amplificateur VGA 2 et également en ajustant une résistance d'entrée variable R_{IN}, qui peut être composée par exemple d'un ou plusieurs transistors de type CMOS mis en parallèle. En diminuant la valeur résistive de la résistance d'entrée, cela diminue l'amplitude du signal d'entrée donc du gain de l'amplificateur d'entrée. Dans le cas de transistors de type CMOS utilisés et non représentés, les bornes de drain et sources sont connectées à l'entrée de l'amplificateur d'entrée 2 et la borne de masse. La grille de chaque transistor est commandée par un signal d'adaptation dans une boucle de commande automatique du gain.

La boucle de commande automatique du gain est donc composée de l'amplificateur d'entrée 2, d'un détecteur de pics 3, d'un amplificateur-comparateur 4 ou d'un amplificateur à transconductance, d'un premier composant d'entraînement 6 et d'un second composant d'entraînement 7. Le signal de sortie V_{OUT} de l'amplificateur d'entrée, qui est un signal alternatif, dépend généralement de la fréquence porteuse des signaux captés. Ce signal de sortie est fourni au détecteur de pics conventionnels 3 pour fournir en sortie un signal redressé V_{P}, qui peut être continu, et qui représente l'amplitude du signal d'entrée V_{IN} amplifié par l'amplificateur d'entrée 2. Ce signal redressé V_{P} peut être mémorisé sur un condensateur C_{P} du détecteur de pics 3.

L'amplificateur-comparateur 4 est relié au détecteur de pics pour recevoir le signal redressé V_{P}. Cet amplificateur-comparateur 4 est prévu pour déterminer une erreur entre le signal redressé V_{P} représentatif de l'amplitude des signaux amplifiés V_{OUT} par l'amplificateur d'entrée 2, et un signal de référence V_{R}, qui est représentatif d'un seuil défini d'amplitude. Le signal redressé et le signal de référence sont généralement une tension redressée V_{P} et une tension de référence V_{R} fournies à l'entrée de l'amplificateur-comparateur 4. La tension redressée V_{P} est fournie à l'entrée positive, alors que la tension de référence V_{R} est fournie à l'entrée négative de l'amplificateur-comparateur 4.

En fonction de l'erreur déterminée entre les deux tensions comparées, un signal d'adaptation sous la forme d'un courant ou d'une tension d'adaptation V_{AGC} est fourni par l'amplificateur-comparateur 4. Un condensateur d'intégration C_{INT} est encore disposé en sortie de l'amplificateur-comparateur 4, si le signal de sortie de l'amplificateur-comparateur est sous la forme d'un courant. Ce signal d'adaptation V_{AGC} est fourni au premier composant d'entraînement 6 pour adapter le gain directement de l'amplificateur d'entrée 2, et au second composant d'entraînement 7 pour adapter la résistance de dérivation R_{IN}.

Le gain de cet amplificateur d'entrée 2 est adapté de deux manières différentes à une valeur de fonctionnement stable, jusqu'à ce que l'écart entre la tension redressée V_{P} et la tension de référence V_{R} devient proche de zéro. Cependant l'adaptation de ladite résistance de dérivation R_{IN} à une valeur d'atténuation convenable est relativement difficile à atteindre dans cette configuration présentée à la figure 1, ce qui constitue un inconvénient.

Une seconde forme de réalisation d'un tel circuit électronique 1 de l'état de la technique est représentée à la figure 2, qui est de conception similaire à la forme de réalisation décrite ci-dessus en référence à la figure 1. Dans ce cas de figure, l'amplificateur d'entrée 2, qui peut être un amplificateur du type VGA, comprend deux entrées. Les deux entrées sont prévues pour recevoir un premier signal d'entrée V_{IN+} et un second signal d'entrée V_{IN-}, qui est de phase opposée à 180° du premier signal d'entrée V_{IN+}. Ces signaux d'entrée proviennent généralement de signaux captés par une antenne et mis en forme dans un étage de mise en forme traditionnel.

La boucle de commande automatique comprend en plus de l'amplificateur d'entrée 2, une unité de commande automatique du gain 5, qui peut être composé d'un détecteur de pics et d'un amplificateur-comparateur comme expliqué en référence à la figure 1. L'unité AGC fournit un signal d'adaptation V_{AGC} à un premier composant d'entraînement 6 pour adapter le gain directement de l'amplificateur d'entrée 2, et à un second composant d'entraînement 7 pour adapter la résistance de dérivation R_{IN}. Cette résistance de dérivation R_{IN} est dans cet exemple au moins un transistors MOS, par exemple un transistor PMOS, dont le drain est relié à la première entrée V_{IN+} et la source est reliée à la seconde entrée V_{IN-}, et la grille est commandée par le second composant d'entraînement 7. Généralement l'adaptation de la résistance de dérivation R_{IN} de manière douce est difficile à mettre en œuvre, ce qui peut constituer un inconvénient d'une telle atténuation d'entrée de l'amplificateur d'entrée. Si la résistance de source est Rs, il faut que le signal soit atténué par le facteur R_{IN}/(R_{IN}+Rs).

Finalement une troisième forme de réalisation d'un tel circuit électronique 1 de l'état de la technique est représentée à la figure 3 avec un ajustement de la résistance variable d'entrée équivalente à une commande numérique fonction de différents niveaux de tension de référence. Le circuit électronique 1 comprend une boucle de commande automatique du gain de principe semblable à celle décrite en référence aux figures 1 et 2. La boucle de commande automatique de gain comprend également l'amplificateur d'entrée 2 à deux entrées V_{IN+} et V_{IN-}, et l'unité de commande automatique du gain 5, qui peut être composé d'un détecteur de pics et d'un amplificateur-comparateur comme expliqué en référence à la figure 1. L'unité AGC fournit une tension d'adaptation V_{AGC}, qui est comparée à plusieurs niveaux de référence V_{REF1}, V_{REF2}, V_{REFN} dans plusieurs comparateurs à hystérèse 11, 12, 13. Plusieurs résistances de dérivation R_{IN1}, R_{IN2}, R_{INN} en parallèle, qui sont composées chacune par un transistor PMOS, sont connectées par leur drain et leur source, aux deux entrées V_{IN+} et V_{IN-}. Ces résistances de dérivation sont commandées chacune par un comparateur correspondant.

Une commande numérique peut ainsi être appliquée en fonction des N niveaux de tension de référence V_{REF1}, V_{REF2}, V_{REFN} pour commander la conduction ou non des N résistances en fonction du niveau de la tension V_{AGC}. Ainsi l'impédance d'entrée par la mise en parallèle des résistances de dérivation permet d'atténuer les signaux d'entrée de l'amplificateur d'entrée 2 sur une très grande gamme. Cela permet un ajustement du gain de l'amplificateur de manière plus fine, par rapport à l'utilisation d'un unique comparateur et d'un unique transistor PMOS comme résistance de dérivation. Cependant l'atténuation des signaux d'entrée et donc l'adaptation du gain de l'amplificateur d'entrée s'opère selon différents paliers de tension, ce qui complique la réalisation d'un tel ajustement. De plus, cet agencement de comparateurs ne peut pas convenir dans toutes les situations d'adaptation requise, ce qui constitue un inconvénient.

La demande de brevet US 2009/0201091 A1 décrit un circuit contrôleur ayant un atténuateur. L'atténuateur est connecté à un circuit de polarisation. L'atténuateur comprend un transistor FET de dérivation, dont la source est reliée à la masse et le drain est relié à un nœud d'un chemin résistif de l'atténuateur. La grille du transistor de dérivation est reliée à une grille et un drain d'un transistor FET du circuit de polarisation, dont la source est reliée à la masse. L'agencement du transistor de réplique du circuit de polarisation et le transistor de dérivation de l'atténuateur forme un miroir de courant.

Le brevet US 4,839,611 décrit un circuit électronique avec un atténuateur pour l'entrée d'un amplificateur. L'atténuateur est contrôlé par une unité de commande automatique du gain, qui est reliée entre la sortie de l'amplificateur et une entrée de commande de l'atténuateur. L'unité de commande automatique du gain fournit une tension de commande à l'atténuateur selon la tension de sortie de l'amplificateur pour ajuster proportionnellement la tension à l'entrée de l'amplificateur. L'atténuateur est principalement un atténuateur passif continûment variable avec un élément résistif passif le long d'un chemin d'un signal d'entrée de l'amplificateur.

La demande de brevet WO 2011/080536 A1 décrit un agencement de transistors contrôlables par une tension de commande, afin d'adapter la valeur résistive d'une résistance d'entrée, par exemple la résistance d'entrée d'un amplificateur.

### RESUME DE L'INVENTION

L'invention a donc pour but de pallier aux inconvénients de l'état de la technique susmentionné en fournissant un circuit électronique muni d'une unité d'atténuation de deux signaux d'entrée d'un amplificateur d'entrée, qui permette une atténuation douce des signaux d'entrée, et qui soit facile à mettre en œuvre tout en accroissant la flexibilité du circuit électronique.

A cet effet, l'invention concerne un circuit électronique muni d'une unité d'atténuation de deux signaux d'entrée d'un amplificateur d'entrée, qui comprend les caractéristiques définies dans la revendication indépendante 1.

Des formes particulières d'exécution du circuit électronique muni d'une unité d'atténuation de deux signaux d'entrée d'un amplificateur d'entrée sont définies dans les revendications dépendantes 2 à 10.

Un avantage du circuit électronique muni d'une unité d'atténuation de deux signaux d'entrée d'un amplificateur d'entrée, réside dans le fait que l'atténuation des signaux d'entrée est effectuée avec une transition adoucie autour d'une valeur d'amplitude attendue des signaux d'entrée. Pour ce faire, l'unité d'atténuation comprend un moyen de comparaison de courants ou de tensions. Le moyen de comparaison de courants ou de tensions permet de fournir un courant d'atténuation à un transistor de réplique en fonction de la différence entre un courant d'adaptation et un courant de référence ou entre une tension d'adaptation et une tension de référence. Le courant d'adaptation ou la tension d'adaptation sont fournis par une unité de commande automatique du gain sur la base du niveau détecté d'amplitude du signal de sortie de l'amplificateur d'entrée. Le transistor de réplique est monté en parallèle avec un transistor de dérivation constituant une résistance de dérivation branchée à deux entrées de l'amplificateur d'entrée. L'atténuation de l'amplitude des signaux d'entrée est ainsi dynamiquement effectuée en continu par l'agencement du transistor de réplique relié au transistor de dérivation.

### BREVE DESCRIPTION DES FIGURES

Les buts, avantages et caractéristiques d'un circuit électronique muni d'une unité d'atténuation d'au moins un signal d'entrée d'un amplificateur d'entrée apparaîtront mieux dans la description suivante sur la base de formes d'exécution non limitatives illustrées par les dessins sur lesquels :
la figure 1 citée ci-devant représente un premier exemple de circuit électronique ayant des moyens d'atténuation d'au moins un signal d'entrée d'un amplificateur d'entrée dans une boucle de commande automatique du gain de l'état de la technique,
la figure 2 citée ci-devant représente un second exemple de circuit électronique ayant des moyens d'atténuation de signaux d'entrée d'un amplificateur d'entrée dans une boucle de commande automatique du gain de l'état de la technique,
la figure 3 citée ci-devant représente un troisième exemple de circuit électronique ayant des moyens d'atténuation de signaux d'entrée d'un amplificateur d'entrée dans une boucle de commande automatique du gain de l'état de la technique,
la figure 4 représente une forme d'exécution d'un circuit électronique muni d'une unité d'atténuation de deux signaux d'entrée d'un amplificateur d'entrée dans une boucle de commande automatique du gain selon l'invention,
la figure 5 représente un graphe de la valeur résistive de résistance de dérivation d'atténuation d'au moins un signal d'entrée par rapport au signal d'adaptation fourni par l'unité de commande automatique du gain du circuit électronique selon l'invention, et
la figure 6 représente un graphe de la valeur résistive de résistance de dérivation d'atténuation d'au moins un signal d'entrée par rapport au signal d'adaptation fourni par l'unité de commande automatique du gain du circuit électronique selon l'invention en tenant compte d'une hystérèse dans l'unité d'atténuation.

### DESCRIPTION DETAILLEE DE L'INVENTION

Dans la description suivante, tous les composants électroniques du circuit électronique, qui est muni d'une unité d'atténuation d'au moins un signal d'entrée d'un amplificateur d'entrée dans une boucle de commande automatique du gain, qui sont bien connus de l'homme du métier dans ce domaine technique ne seront relatés que de manière simplifiée.

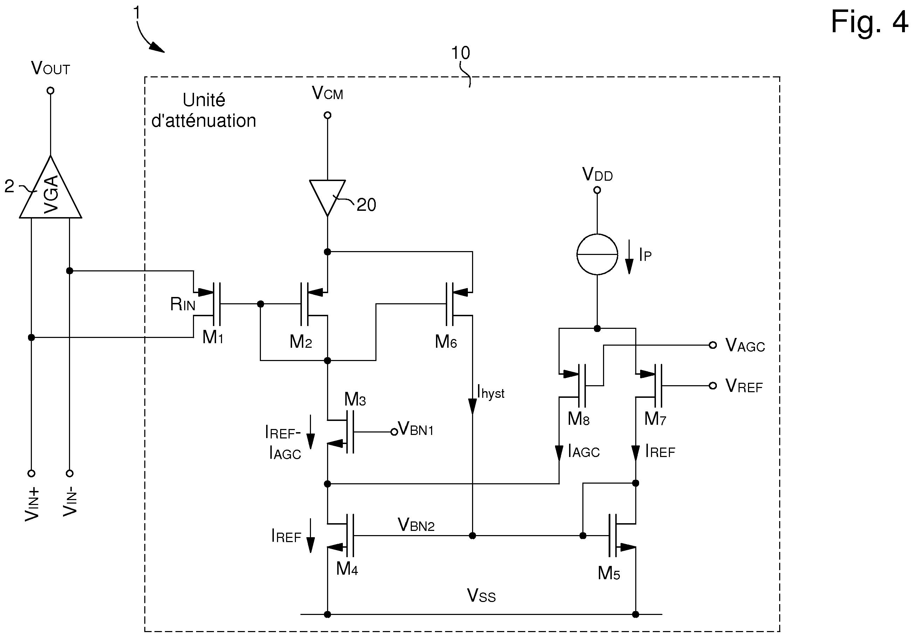

La figure 4 représente une forme d'exécution du circuit électronique 1, qui est muni notamment d'une unité d'atténuation 10 de signaux d'entrée V_{IN+} et V_{IN-} d'un amplificateur d'entrée 2. Ces deux signaux d'entrée à fréquence déterminée, qui peuvent être en opposition de phase à 180° l'un de l'autre, sont fournis à deux entrées de l'amplificateur d'entrée 2, qui peut être un amplificateur du type VGA ou LNA. Ces deux signaux V_{IN+} et V_{IN-} peuvent provenir de signaux captés par une antenne et mis en forme dans un étage de mise en forme avant l'amplificateur d'entrée. Cependant l'amplificateur d'entrée 2 peut également ne recevoir qu'un seul signal d'entrée avec l'unité d'atténuation 10 prévue pour atténuer l'amplitude de ce seul signal d'entrée, mais un amplificateur qui est prévu pour ne recevoir qu'un seul signal d'entrée n'est pas en accord avec l'invention.

Le circuit électronique 1 comprend en plus de l'amplificateur d'entrée 2 dans une boucle de commande automatique du gain, une unité de commande automatique du gain non représentée sur cette figure 4. Cette unité de commande automatique du gain est directement reliée à la sortie de l'amplificateur d'entrée 2 et capable de déterminer l'amplitude du signal de sortie V_{OUT} de l'amplificateur d'entrée 2. Sur la base de l'amplitude détectée, un signal V_{AGC} est fourni notamment à l'unité d'atténuation 10 des signaux d'entrée, mais peut également être fourni à l'amplificateur d'entrée dans un mode spécifique de réalisation. L'adaptation du gain de l'amplificateur d'entrée 2 peut ainsi être effectuée traditionnellement par l'adaptation du gain directement dans l'amplificateur d'entrée, mais également et selon l'invention par l'unité d'atténuation 10.

Il peut être prévu dans l'unité de commande automatique du gain d'utiliser un détecteur de pics pour détecter le niveau d'amplitude du signal de sortie V_{OUT} de l'amplificateur d'entrée 2. L'unité AGC peut également comprendre un amplificateur-comparateur pour comparer le signal redressé du détecteur de pics avec un signal de référence fonction de l'amplitude souhaitée du signal de sortie. Ceci permet à l'unité AGC de fournir le signal d'adaptation V_{AGC} pour l'unité d'atténuation 10.

Le signal d'adaptation V_{AGC} peut être une tension d'adaptation V_{AGC} ou également un courant d'adaptation dans une variante de réalisation non illustrée, mais expliquée également ci-après. La tension d'adaptation V_{AGC} est d'un niveau dépendant directement du niveau d'amplitude V_{OUT} du signal de sortie de l'amplificateur d'entrée 2. Si l'amplitude du signal de sortie V_{OUT} est au-dessus d'un seuil de référence déterminé, la tension d'adaptation a pour effet de commander l'unité d'atténuation 10 de manière à atténuer plus ou moins fortement l'amplitude des signaux d'entrée V_{IN+} et V_{IN-} de l'amplificateur d'entrée 2. Par contre, dans le cas contraire, où l'amplitude du signal de sortie V_{OUT} est au-dessous du seuil de référence déterminé, une faible atténuation ou aucune atténuation d'amplitude n'est effectuée comme expliqué ci-après. Dans ce cas, il ne subsiste qu'une résistance de dérivation de grande valeur en sortie de l'unité d'atténuation 10, qui relie les deux entrées de l'amplificateur d'entrée 2 ou, dans une réalisation qui n'est pas en accord avec l'invention, une entrée et une borne d'une source de tension d'alimentation non représentée.

Comme représenté sur la figure 4, l'unité d'atténuation 10 comprend un moyen de comparaison pour comparer un signal de référence V_{REF} et un signal d'adaptation V_{AGC}. La sortie de ce moyen de comparaison contrôle un courant d'atténuation. L'intensité du courant d'atténuation est définie entre une valeur minimum, qui peut être 0 A, et une valeur maximum, qui peut être déterminée par un premier courant, tel qu'un courant de référence I_{REF} préalablement établi par l'intermédiaire d'une source de courant de polarisation I_{P}.

Le courant d'atténuation est prévu pour être fourni à un transistor de réplique M2, qui est monté en diode et d'un premier type de conductivité, et qui contrôle par une électrode de commande, un transistor de dérivation M1, qui est d'un premier type de conductivité. Les électrodes de courant de ce transistor de dérivation M1 sont respectivement reliées à au moins une entrée et une borne d'une source de tension d'alimentation, et de préférence à deux entrées de l'amplificateur d'entrée 2. En fonction de la valeur de courant passant à travers le transistor de réplique M2, la résistance de dérivation R_{IN} établie par le transistor M1 varie entre une valeur résistive minimale et une valeur résistive maximale.

Généralement la valeur minimum du courant est représentative du fait que l'amplitude du signal de sortie V_{OUT} de l'amplificateur d'entrée 2 est en dessous d'un seuil de référence prédéterminé dans l'unité de commande automatique du gain. Dans ces conditions, l'unité d'atténuation 10 est prévue pour ne pas commander le transistor de dérivation M1 de manière que la résistance de dérivation est à une valeur maximale R_{MAX}. Par contre, la valeur maximum du courant est représentative du fait que l'amplitude du signal de sortie V_{OUT} de l'amplificateur d'entrée 2 est en principe bien au-dessus du seuil de référence prédéterminé. Dans ces conditions, l'unité d'atténuation 10 est prévue pour commander le transistor de dérivation M1 de manière à ce que la résistance de dérivation est à une valeur minimale R_{MIN}.

Bien entendu, une adaptation dynamique de valeur résistive de la résistance de dérivation R_{IN} de manière douce et grâce à la variation douce du courant à travers le transistor de réplique M2 peut être effectuée. Ce transistor M2 a une de ses électrodes de courant, qui est l'électrode de drain ou de collecteur, reliée à l'électrode de commande, qui est l'électrode de grille ou de base. L'autre électrode de courant du transistor M2, qui est l'électrode de source ou d'émetteur, est reliée à travers une cellule tampon de tension 20 à une tension en mode commun V_{CM}, qui est également la tension en mode commun du signal d'entrée alternatif ou des signaux d'entrée V_{IN+} et V_{IN-} alternatifs. Cette tension en mode commun V_{CM} est une tension moyenne DC du ou des signaux d'entrée. De ce fait, les deux transistors M1 et M2, qui sont deux transistors de taille identique, peuvent constituer un miroir de courant, avec le transistor de réplique M2, qui commande le transistor de dérivation M1.

Il est à noter qu'il est important que la tension V_{CM} soit appliquée à la source ou l'émetteur du transistor de réplique M2 étant donné que ce transistor de réplique est très similaire au transistor de dérivation M1. Généralement la tension en mode commun V_{CM} peut être égale à la tension haute V_{DD} de la source de tension d'alimentation. Ainsi il est très facile de connecter directement la source du transistor de réplique M2 à la tension haute V_{DD}, ce qui permet de retirer la cellule tampon de tension 20.

De préférence, les deux transistors M1 et M2 sont des transistors PMOS dans cette forme d'exécution et pour lesquels la source du transistor de réplique M2 est reliée à la cellule tampon de tension 20 et la source du transistor de dérivation M1 est reliée à une première entrée de l'amplificateur d'entrée 2. Le drain du transistor de dérivation M1 est relié soit à une des bornes de la source de tension d'alimentation pour un amplificateur d'entrée à une seule entrée, soit à une seconde entrée de l'amplificateur d'entrée 2.

Le moyen de comparaison du signal de référence V_{REF} et du signal d'adaptation V_{AGC} de l'unité d'atténuation 10 est maintenant décrit en détail. De préférence, le moyen de comparaison dans cette forme d'exécution permet de comparer une tension de référence V_{REF} avec une tension d'adaptation V_{AGC} fournie par l'unité de commande automatique du gain. Il peut être prévu de fixer la tension de référence V_{REF} à une valeur voisine de celle relative au seuil de référence d'amplitude de l'unité de commande automatique du gain. Plus la tension d'adaptation V_{AGC} est faible, c'est-à-dire en dessous de la tension de référence V_{REF}, et plus l'amplitude du signal de sortie V_{OUT} de l'amplificateur d'entrée 2 est faible. Par contre quand la tension d'adaptation V_{AGC} est égale ou supérieure à la tension de référence V_{REF}, l'amplitude du signal de sortie V_{OUT} de l'amplificateur d'entrée 2 est trop forte. Cette amplitude du signal de sortie V_{OUT} doit en principe être atténuée par l'adaptation de la résistance de dérivation R_{IN} en entrée de l'amplificateur d'entrée 2.

Comme représenté à la figure 4, le moyen de comparaison comprend une paire de transistors d'entrée M7 et M8 d'un premier type de conductivité, comme les transistors M1 et M2. Les sources ou émetteurs des transistors d'entrée M7 et M8 sont reliés à une source de courant de polarisation I_{P}, qui est reliée à une première borne d'une source de tension d'alimentation, qui peut être la borne de potentiel haut V_{DD}. La grille ou la base du premier transistor d'entrée M7 est agencée pour recevoir la tension de référence V_{REF}, alors que la grille ou la base du second transistor d'entrée M8 est agencée pour recevoir la tension d'adaptation V_{AGC}. De préférence, ces transistors d'entrée M7 et M8 dans cette forme d'exécution sont des transistors PMOS de dimension identique.

Le drain du premier transistor d'entrée M7 de type PMOS est relié à un premier transistor monté en diode M5 d'un second type de conductivité d'un miroir de courant, qui est de préférence un transistor du type NMOS. La source de ce transistor monté en diode M5 est reliée à une seconde borne de la source de tension d'alimentation, qui peut être la borne de potentiel bas V_{SS}. Un second transistor M4 du type NMOS du miroir de courant est relié par sa grille à la grille du premier transistor monté en diode M5. La source du second transistor M4 du type NMOS est reliée à la borne de potentiel bas V_{SS} de la source de tension d'alimentation, alors que son drain est prévu pour tirer un courant correspondant au premier courant I_{REF} traversant le premier transistor monté en diode M5. Le drain du second transistor M4 est relié au drain du second transistor d'entrée M8 de type PMOS, et également à la source ou l'émetteur d'un transistor de sortie M3 du moyen de comparaison d'un second type de conductivité. Ce transistor de sortie M3 est de préférence un transistor du type NMOS.

La grille du transistor de sortie M3 est commandée par une tension de polarisation V_{BN1} déterminée, alors que les grilles des premier et second transistors M4 et M5 du miroir de courant sont à une tension de fonctionnement V_{BN2} déterminée en fonction du courant traversant le transistor monté en diode M5. Le drain du transistor de sortie M3 est relié à la grille et au drain du transistor de réplique M2 monté en diode pour lui fournir le courant d'atténuation de sortie du moyen de comparaison sur la base de la comparaison entre la tension d'adaptation V_{AGC} et la tension de référence V_{REF}.

Lorsque le signal de sortie V_{OUT} de l'amplificateur d'entrée 2 est à un niveau en dessous du seuil de référence déterminé dans l'unité de commande automatique du gain, la tension d'adaptation V_{AGC} fournie à l'unité d'atténuation 10 est également en dessous de la tension de référence V_{REF}. Le courant de polarisation I_{P} passe principalement par le second transistor d'entrée M8 pour générer le second courant, qui est un courant d'adaptation I_{AGC}. Le premier courant, qui est un courant de référence I_{REF} à travers le premier transistor d'entrée M7, est ainsi égal au courant (I_{P}-I_{AGC}). Ce second courant d'adaptation I_{AGC} est fourni au drain du second transistor M4 du miroir de courant.

Comme dans ce cas de figure, le second courant I_{AGC} est plus grand que le premier courant I_{REF}, le courant résultant est inférieur à 0 A. Cela a pour conséquence qu'aucun courant d'atténuation ne traverse le transistor de sortie M3, et le transistor de réplique M2. Le transistor M3 agit donc comme un transistor tampon, pour opérer la soustraction entre le premier courant I_{REF} et le second courant I_{AGC}. La résistance R_{IN} définie par le transistor de dérivation M1 est donc à une valeur résistive maximale R_{MAX}.

Pour une tension d'adaptation V_{AGC} fournie à l'unité d'atténuation 10 égale à la tension de référence V_{REF}, le courant de polarisation I_{P} est réparti sensiblement de manière égale dans chaque transistor d'entrée M7 et M8. Le premier courant, qui est le courant de référence I_{REF}, est sensiblement égal au second courant, qui est le courant d'adaptation I_{AGC}. Le courant d'atténuation résultant à travers le transistor de sortie M3 est proche de 0 A, ce qui n'influence pas la valeur résistive de la résistance R_{IN} définie par le transistor de dérivation M1. Par contre dès l'instant, où la tension d'adaptation V_{AGC} est supérieure à la tension de référence V_{REF}, le courant de polarisation I_{P} passe principalement par le premier transistor d'entrée M7. Ainsi un courant d'atténuation résultant à travers le transistor de sortie M3 et le transistor de réplique M2 est supérieur à 0 A, ce qui a pour conséquence de diminuer la résistance de dérivation R_{IN} définie par le transistor de dérivation M1 jusqu'à une valeur minimale R_{MIN}. Ce courant d'atténuation résultant I_{REF}-I_{AGC} est à une valeur maximale égale à I_{P}, quand la tension d'adaptation V_{AGC} est supérieure de 50 à 100 mV par rapport à la tension de référence V_{REF}.

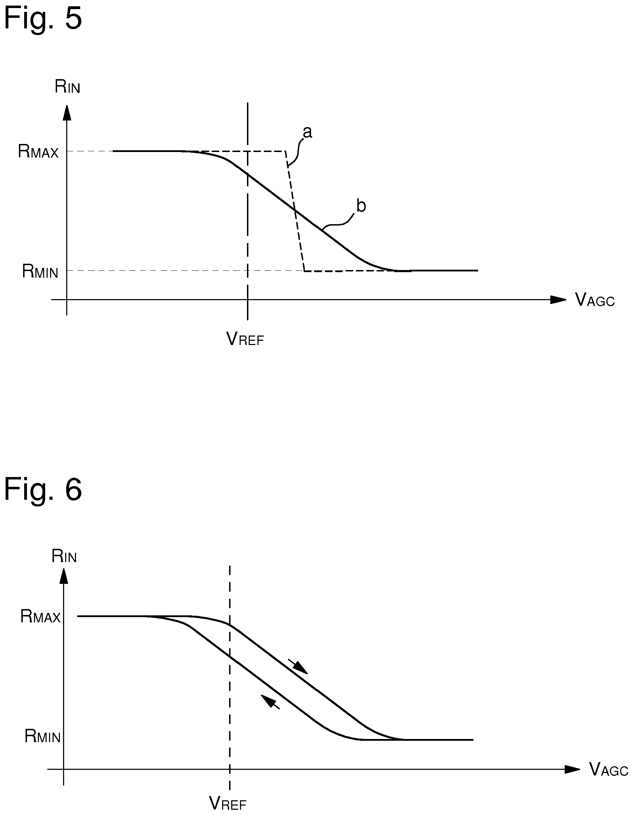

Comme l'adaptation du gain de l'amplificateur d'entrée 2 s'opère doucement autour de l'amplitude attendue du signal de sortie V_{OUT}, la transition entre une valeur résistive maximale et une valeur résistive minimale de la résistance de dérivation R_{IN} est également effectuée de manière douce par l'unité d'atténuation 10. Sur la figure 5, il est représenté cette transition entre une valeur résistive maximale R_{MAX} et une valeur résistive minimale R_{MIN}, ou inversement sur la courbe b pour une tension d'adaptation V_{AGC} par rapport à une tension de référence V_{REF} dans une unité d'atténuation de la présente invention.

Par contre sur la figure 5, il est également représenté la courbe a relative à une commande numérique d'adaptation de la résistance de dérivation R_{IN} comme représenté à la figure 3 de l'état de la technique avec un unique comparateur. Sur cette courbe a, la transition entre la valeur résistive R_{MAX} et la valeur résistive minimale R_{MIN}, ou inversement, est opérée relativement brutalement. Ceci ne permet pas d'atténuer doucement les signaux d'entrée de l'amplificateur d'entrée et aucune adaptation dynamique fonction du niveau d'amplitude du signal de sortie V_{OUT} de l'amplificateur d'entrée n'est opérée.

Pour pouvoir augmenter la résistivité du circuit par rapport au bruit, il est possible de prévoir encore un chemin à hystérèse pour le moyen de comparaison. Pour ce faire, un transistor à hystérèse M6 du premier type de conductivité, est connecté en parallèle du transistor de réplique M2. Ce transistor à hystérèse M6 est de préférence un transistor du type PMOS, dont la source est reliée à la source du transistor de réplique M2 pour être connectée à la tension en mode commun V_{CM} à travers la cellule tampon de tension 20. La grille du transistor à hystérèse M6 est reliée à la grille et au drain du transistor de réplique M2, alors que le drain du transistor à hystérèse M6 est relié à la grille et au drain du premier transistor monté en diode M5 du miroir de courant. L'ensemble composé par le transistor de dérivation M1, le transistor de réplique M2 et le transistor à hystérèse M6 forme également un miroir de courant, dont le courant dans chaque transistor peut être contrôlé par le transistor de réplique monté en diode M2.

Au moment où la tension d'adaptation V_{AGC} est égale à la tension de référence V_{REF}, le premier courant est égal au second courant, ce qui a pour conséquence que le transistor de sortie M3 ne fournit encore aucun courant d'atténuation au transistor de réplique monté en diode M2. Le courant miroité dans le transistor à hystérèse M6 est donc égal à 0 A. Lorsque la tension d'adaptation V_{AGC} devient supérieure à la tension de référence V_{REF}, le premier courant I_{REF} devient plus grand que le second courant I_{AGC}. Le transistor de sortie M3 fournit, sans tenir compte encore du transistor à hystérèse M6, le courant d'atténuation correspondant à I_{REF}-I_{AGC}. Ce courant d'atténuation est miroité dans le transistor à hystérèse M6. Ainsi le premier transistor monté en diode M5 reçoit le premier courant I_{REF} et le courant à hystérèse I_{hyst} du transistor M6. Le courant d'atténuation devient dans ce cas (I_{REF}+I_{hyst})-I_{AGC}. Pour avoir ce courant égal à 0 A, cela signifie qu'il faut appliquer une tension d'adaptation V_{AGC} correspondant à la tension de référence V_{REF} additionnée d'un écart en tension ΔV. Un effet à hystérèse est ainsi simplement obtenu par le branchement du transistor à hystérèse M6 du type PMOS pour une variation résistive de la résistance de dérivation R_{IN} de manière dynamique pour l'adaptation du gain de l'amplificateur d'entrée.

On peut remarquer l'effet du chemin à hystérèse sur la figure 6, qui représente une courbe de la valeur résistive de la résistance de dérivation par rapport à la variation de la tension d'adaptation. Lorsque la tension d'adaptation V_{AGC} augmente depuis une valeur initiale, pour laquelle le courant d'atténuation est égal à 0 A, la valeur résistive de la résistance de dérivation varie depuis une valeur maximale R_{MAX} vers une valeur minimale R_{MIN} selon la courbe la plus à droite sur la figure 6. Par contre, lorsque la tension d'adaptation V_{AGC} diminue avec une valeur résistive de la résistance d'atténuation depuis une valeur minimale R_{MIN} vers une valeur maximale R_{MAX}, la variation de résistance suit la courbe la plus à gauche. Ceci est dû à la variation du courant d'hystérèse ajouté au premier courant dans le premier transistor monté en diode du miroir de courant.

A titre d'exemple non limitatif de la forme d'exécution présentée à la figure 4, la tension d'alimentation du circuit électronique 1 peut être définie entre 1.2 V et 3.6 V et dépend bien entendu de la technologie semiconductrice. Cette technologie peut être une technologie bipolaire ou préférentiellement une technologie CMOS par exemple. Selon la technologie utilisée, la tension d'alimentation peut même être d'une valeur de l'ordre de 0.8 V. En fonction du courant de polarisation I_{P} établi, normalement le premier courant et le second courant peuvent varier jusqu'à une valeur maximale de l'ordre de 100 nA, mais il est possible d'avoir une variation pouvant aller jusqu'à une valeur de 1 µA en fonction de la technologie utilisée. La tension de référence V_{REF} peut être fixée à 0.7 V, alors que la tension d'adaptation V_{AGC} peut varier autour de 0.7 V. La tension de grille V_{BN1} du transistor de sortie M3 peut être fixée à 0.9 V, alors que la tension de grille du miroir de courant est proche de 0.7 V. La valeur résistive minimale R_{MIN} de la résistance de dérivation définie par le transistor de dérivation M1 peut être de l'ordre de 100 kOhms, alors que la valeur résistive maximale R_{MAX} de la résistance de dérivation, quand le transistor de dérivation M1 est non conducteur peut être de l'ordre de 1 à 10 MOhms. La tension en mode commun V_{CM} peut être de l'ordre de 1.2 V par exemple.

Selon une variante de réalisation du circuit électronique, il peut être prévu qu'une comparaison de courant soit effectuée par le moyen de comparaison de l'unité d'atténuation 10. Pour une telle comparaison de courant, une même structure décrite en référence à la figure 4 peut être reprise. Cependant la source de courant de polarisation I_{P}, ainsi que les premier et second transistors d'entrée M7 et M8 ne sont plus utilisés. Il ne subsiste qu'une source de courant de référence I_{REF}, qui fournit un courant continu fixe de référence I_{REF} au premier transistor monté en diode M5 du miroir de courant. Pour cette comparaison de courant, l'unité de commande automatique est prévue pour fournir un courant d'adaptation I_{AGC}, qui varie inversement à l'amplitude du signal de sortie V_{OUT} de l'amplificateur d'entrée 2. Cela signifie que plus l'amplitude du signal de sortie V_{OUT} est grande et plus le courant I_{AGC} est faible, et inversement plus l'amplitude du signal de sortie V_{OUT} est petite et plus le courant I_{AGC} est fort. Ainsi quand l'amplitude du signal de sortie V_{OUT} est au-dessus d'un seuil de référence d'amplitude défini dans l'unité de commande automatique du gain, le courant d'adaptation I_{AGC} doit être plus petit que le courant de référence I_{REF}. Ceci permet d'adapter la résistance de dérivation R_{IN} à une faible valeur résistive afin de diminuer par conséquent le gain de l'amplificateur d'entrée.

Il peut également être prévu pour le moyen de comparaison de courants d'utiliser le chemin à hystérèse comme décrit en référence à la figure 4. Le courant à hystérèse fourni par le transistor à hystérèse M6 du type PMOS est additionné au courant de référence dans le transistor monté en diode M5 du type NMOS. Une courbe de variation sensiblement équivalente du courant d'adaptation I_{AGC} par rapport à la valeur résistive de la résistance de dérivation peut être illustrée comme pour la figure 6 précédemment décrite.

Il est encore à noter que le circuit électronique 1 avec l'unité d'atténuation 10 présentés à la figure 4 peut être réalisé selon une structure inverse en remplaçant chaque transistor PMOS par un transistor NMOS, défini comme un premier type de conductivité. De plus, chaque transistor NMOS de la figure 4 est remplacé par un transistor PMOS défini comme un second type de conductivité. Cependant le miroir de courant composé des transistors M4 et M5 du type PMOS dans cette nouvelle variante de réalisation est relié à la borne de potentiel haut V_{DD} de la source de tension d'alimentation, alors que la source de courant de polarisation I_{P} est reliée à la borne de potentiel bas V_{SS} de la source de tension d'alimentation. Les sources du transistor de réplique M2 du type NMOS et du transistor à hystérèse M6 du type NMOS sont reliées à la tension en mode commun V_{CM}. Le transistor de dérivation du type NMOS est relié par sa grille à la grille du transistor de réplique M2 et à une ou deux entrées de l'amplificateur d'entrée 2.

Il est important que les transistors M1, M2 et M6 soient reliés à une même tension en mode commun V_{CM} par leur source de manière à bien répliquer le courant d'atténuation du transistor de réplique M2 dans les deux autres transistors M1 et M6. Une variation de résistance de dérivation est effectuée doucement pour l'adaptation du gain de l'amplificateur d'entrée 2. Dans ce mode de réalisation, il est possible d'avoir une tension en mode commun proche de 0 V, ce qui n'était pas forcément le cas pour la forme d'exécution décrite en référence à la figure 4.

Bien entendu pour une version de comparaison de courants dans l'unité d'atténuation inverse de celle décrite ci-dessus, il peut également être remplacé tous les transistors du type NMOS représentés à la figure 4, par des transistors du type PMOS. Tous les autres transistors du type PMOS de la figure 4 doivent aussi être remplacés par des transistors du type NMOS. Un même branchement aux bornes de la source de tension d'alimentation doit être effectué comme expliqué sur la variante de réalisation susmentionnée.

L'unité d'atténuation du circuit électronique peut également être réalisée par des transistors bipolaires avec un même agencement comme représenté à la figure 4. Cependant pour le transistor de dérivation M1 avec le transistor de réplique M2, il est plus facile d'utiliser des transistors MOS pour bien contrôler la résistance de dérivation en entrée de l'amplificateur d'entrée, et contrôler toute variation de tension d'alimentation, de température ou du procédé de fabrication du circuit électronique.

A partir de la description qui vient d'être faite, plusieurs variantes du circuit électronique muni d'une unité d'atténuation de deux signaux d'entrée d'un amplificateur d'entrée dans une boucle de commande automatique du gain peuvent être conçues par l'homme du métier sans sortir du cadre de l'invention définie par les revendications. Il peut être envisagé de connecter au moins deux unités d'atténuation pour atténuer un ou deux signaux d'entrée de l'amplificateur d'entrée. Chacune des unités d'atténuation est agencée avec un signal de référence pour la comparaison avec le signal d'adaptation légèrement différent l'un de l'autre pour adapter la résistance totale de dérivation. Il peut être prévu d'ajouter des résistances en série dans le miroir de courant pour linéariser le courant d'atténuation. L'amplificateur d'entrée du type LNA ou VGA peut être apte à amplifier des signaux radiofréquences du type FSK ou PSK captés par une antenne. Il peut s'agir également d'un amplificateur d'entrée disposé après un mélangeur de signaux pour amplifier des signaux intermédiaires à fréquence convertie.

## Revendications

1. Circuit électronique (1) comprenant dans une boucle de commande automatique du gain, un amplificateur d'entrée (2), qui comprend deux entrées pour la réception de deux signaux d'entrée (V_{IN}+, V_{IN}-) à fréquence déterminée, qui sont en opposition de phase à 180° l'un de l'autre, une unité de commande automatique du gain (5) reliée à la sortie de l'amplificateur d'entrée (2) pour détecter un niveau d'amplitude d'un signal de sortie (V_{OUT}) de l'amplificateur d'entrée, et une unité d'atténuation (10) des deux signaux d'entrée (V_{IN}+, V_{IN}-) de l'amplificateur d'entrée (2) sur la base d'un signal d'adaptation (V_{AGC}) fourni par l'unité de commande automatique du gain (5),
**caractérisé en ce que** l'unité d'atténuation (10) comprend un moyen de comparaison pour comparer le signal d'adaptation (V_{AGC}) avec un signal de référence (V_{REF}) et pour fournir un courant d'atténuation, dont l'intensité est fonction de la différence entre le signal d'adaptation (V_{AGC}) et le signal de référence (V_{REF}), à un transistor de réplique monté en diode (M2) d'un premier type de conductivité, qui est relié par une source ou un émetteur à une tension continue moyenne (V_{CM}), qui est une tension continue moyenne des deux signaux d'entrée (V_{IN}+, V_{IN}-) de l'amplificateur d'entrée (2), le transistor de réplique monté en diode (M2) contrôlant un transistor de dérivation (M1) d'un premier type de conductivité, qui définit une résistance de dérivation reliée en entrée de l'amplificateur d'entrée (2), dont la valeur résistive dépend de l'intensité du courant d'atténuation traversant le transistor de réplique monté en diode (M2), et
**en ce que** le transistor de dérivation (M1) est un transistor identique au transistor de réplique (M2), **en ce qu'**une source ou un émetteur du transistor de dérivation (M1) est reliée à une première entrée de l'amplificateur d'entrée (2), et **en ce qu'**un drain ou un collecteur du transistor de dérivation (M1) est relié à une seconde entrée de l'amplificateur d'entrée (2).

2. Circuit électronique (1) selon la revendication 1, pour lequel le moyen de comparaison est prévu pour comparer un signal d'adaptation sous la forme d'une tension d'adaptation (V_{AGC}) et un signal de référence sous la forme d'une tension de référence (V_{REF}), **caractérisé en ce que** le moyen de comparaison comprend une paire de transistors d'entrée (M7, M8) d'un premier type de conductivité relié chacun par leur source ou émetteur à une source de courant de polarisation (I_{P}), qui est reliée à une première borne d'une source de tension d'alimentation, une grille ou base du premier transistor d'entrée (M7) recevant la tension de référence (V_{REF}), alors qu'une grille ou base du second transistor d'entrée (M8) reçoit la tension d'adaptation (V_{AGC}), **en ce qu'**un drain ou collecteur du premier transistor d'entrée (M7) est relié à un premier transistor monté en diode (M5) d'un second type de conductivité d'un miroir de courant, qui comprend un second transistor (M4) d'un second type de conductivité relié par sa grille ou base à la grille ou base du premier transistor monté en diode (M5), des sources ou émetteurs des premier et second transistors (M4, M5) du miroir de courant étant reliés à une seconde borne de la source de tension d'alimentation, et **en ce qu'**un drain ou collecteur du second transistor (M4) du miroir de courant est relié au drain ou collecteur du second transistor d'entrée (M8) et prévu pour fournir le courant d'atténuation au transistor de réplique monté en diode (M2).

3. Circuit électronique (1) selon la revendication 2, **caractérisé en ce que** le moyen de comparaison comprend un transistor de sortie (M3) d'un second type de conductivité, qui est disposé entre le drain ou collecteur du second transistor (M4) du miroir de courant et la grille ou base et le drain ou collecteur du transistor de réplique monté en diode (M2), la conduction du transistor de sortie (M3) pour la fourniture du courant d'atténuation étant contrôlée par une tension de polarisation (V_{BN1}) sur une grille ou base du transistor de sortie (M3).

4. Circuit électronique (1) selon la revendication 1, pour lequel le moyen de comparaison est prévu pour comparer un signal d'adaptation sous la forme d'un courant d'adaptation (I_{AGC}) et un signal de référence sous la forme d'un courant de référence (I_{REF}), **caractérisé en ce que** le moyen de comparaison comprend une source de courant de référence, qui est reliée à une première borne d'une source de tension d'alimentation, pour fournir un courant de référence (I_{REF}) à un premier transistor monté en diode (M5) d'un second type de conductivité d'un miroir de courant, qui comprend un second transistor (M4) d'un second type de conductivité relié par sa grille ou base à la grille ou base du premier transistor monté en diode (M5), des sources ou émetteurs des premier et second transistors (M4, M5) du miroir de courant étant reliés à une seconde borne de la source de tension d'alimentation, et **en ce qu'**un drain ou collecteur du second transistor (M4) du miroir de courant est prévu pour recevoir un courant d'adaptation (I_{AGC}) de l'unité de commande automatique du gain, et pour fournir le courant d'atténuation au transistor de réplique monté en diode (M2) dépendant de la différence entre le courant de référence et le courant d'adaptation.

5. Circuit électronique (1) selon la revendication 4, **caractérisé en ce que** le moyen de comparaison comprend un transistor de sortie (M3) d'un second type de conductivité, qui est disposé entre le drain ou collecteur du second transistor (M4) du miroir de courant et la grille ou base et le drain ou collecteur du transistor de réplique monté en diode (M2), la conduction du transistor de sortie (M3) pour la fourniture du courant d'atténuation étant contrôlée par une tension de polarisation (V_{BN1}) sur une grille ou base du transistor de sortie (M3).

6. Circuit électronique (1) selon l'une des revendications 2 à 5, **caractérisé en ce que** le transistor de dérivation (M1), le transistor de réplique (M2) et les premier et second transistors d'entrée (M7, M8) sont des transistors du type PMOS, **en ce que** les premier et second transistors (M4, M5) du miroir de courant et le transistor de sortie (M3) sont des transistors du type NMOS, **en ce que** la source de courant de polarisation (I_{P}) est reliée à une borne de potentiel haut (V_{DD}) de la source de tension d'alimentation, alors que les premier et second transistors (M4, M5) du miroir de courant sont reliés à une borne de potentiel bas (V_{SS}) de la source de tension d'alimentation.

7. Circuit électronique (1) selon l'une des revendications 2 à 5, **caractérisé en ce que** le transistor de dérivation (M1), le transistor de réplique (M2) et les premier et second transistors d'entrée (M7, M8) sont des transistors du type NMOS, **en ce que** les premier et second transistors (M4, M5) du miroir de courant et le transistor de sortie (M3) sont des transistors du type PMOS, **en ce que** la source de courant de polarisation (I_{P}) est reliée à une borne de potentiel bas (V_{SS}) de la source de tension d'alimentation, alors que les premier et second transistors (M4, M5) du miroir de courant sont reliés à une borne de potentiel haut (V_{DD}) de la source de tension d'alimentation.

8. Circuit électronique (1) selon la revendication 1, **caractérisé en ce que** la tension continue moyenne (V_{CM}) est fournie à la source ou l'émetteur du transistor de réplique monté en diode (M2) par l'intermédiaire d'une cellule tampon de tension (20).

9. Circuit électronique (1) selon l'une des revendications 2 et 4, **caractérisé en ce que** le moyen de comparaison comprend un transistor à hystérèse (M6) d'un premier type de conductivité, qui est connecté en parallèle du transistor de réplique monté en diode (M2), une source ou un émetteur du transistor à hystérèse (M6) étant reliée à la source ou émetteur du transistor de réplique (M2), alors qu'une grille ou base du transistor à hystérèse (M6) est reliée à la grille ou base du transistor de réplique monté en diode (M2), et **en ce qu'**un drain ou collecteur du transistor à hystérèse (M6) est relié à la grille ou base et au drain ou collecteur du premier transistor monté en diode (M5) du miroir de courant.

10. Circuit électronique (1) selon la revendication 9, **caractérisé en ce que** le transistor à hystérèse (M6) est du type PMOS ou du type NMOS comme le transistor de réplique (M2) et le transistor de dérivation (M1),

## Patentansprüche

1. Elektronische Schaltung (1), umfassend einen Eingangsverstärker (2) in einer automatischen Verstärkungsregelschleife, der zwei Eingänge zum Empfang von zwei Eingangssignalen (V_{IN}+, V_{IN}-) mit bestimmter Frequenz, die um 180° zueinander phasenverschoben sind, aufweist, eine automatische Verstärkungssteuereinheit (5), die mit dem Ausgang des Eingangsverstärkers (2) verbunden ist, um einen Amplitudenpegel eines Ausgangssignals (V_{OUT}) des Eingangsverstärkers zu erfassen, und eine Einheit (10) zum Abschwächen der beiden Eingangssignale (V_{IN}+, V_{IN}-) des Eingangsverstärkers (2) anhand eines von der automatischen Verstärkungssteuereinheit (5) gelieferten Anpassungssignals (V_{AGC}),
**dadurch gekennzeichnet, dass** die Abschwächungseinheit (10) ein Vergleichsmittel umfasst, um das Anpassungssignal (V_{AGC}) mit einem Referenzsignal (V_{REF}) zu vergleichen und um einen Abschwächungsstrom, dessen Stärke von der Differenz zwischen dem Anpassungssignal (V_{AGC}) und dem Referenzsignal (V_{REF}) abhängt, an einen Repliktransistor (M2) in Diodenschaltung eines ersten Leitfähigkeitstyps zu liefern, der verbunden ist mit einer Source oder einem Emitter mit mittlerer Gleichspannung (V_{CM}), die eine mittlere Gleichspannung der beiden Eingangssignale (V_{IN}+, V_{IN}-) des Eingangsverstärkers (2) ist, wobei der Repliktransistor (M2) in Diodenschaltung einen Abzweigungstransistor (M1) eines ersten Leitfähigkeitstyps steuert, der einen Abzweigungswiderstand definiert, der mit dem Eingang des Eingangsverstärkers (2) verbunden ist und dessen Widerstandswert von der Stärke des Abschwächungsstroms abhängt, der durch den Repliktransistor (M2) in Diodenschaltung fließt, und
dass der Abzweigungstransistor (M1) ein Transistor ist, der mit dem Repliktransistor (M2) identisch ist, dass eine Source oder ein Emitter des Abzweigungstransistors (M1) mit einem ersten Eingang des Eingangsverstärkers (2) verbunden ist und dass ein Drain oder Kollektor des Abzweigungstransistors (M1) mit einem zweiten Eingang des Eingangsverstärkers (2) verbunden ist.

2. Elektronische Schaltung (1) nach Anspruch 1, wobei das Vergleichsmittel dazu vorgesehen ist, ein Anpassungssignal in Form einer Anpassungsspannung (V_{AGC}) und ein Referenzsignal in Form einer Referenzspannung (V_{REF}) zu vergleichen, **dadurch gekennzeichnet, dass** das Vergleichsmittel ein Paar Eingangstransistoren (M7, M8) eines ersten Leitfähigkeitstyps umfasst, die jeweils mit ihrer Source oder ihrem Emitter mit einer Polarisationsstromquelle (I_{P}) verbunden sind, die mit einem ersten Anschluss einer Spannungsversorgungsquelle verbunden ist, wobei ein Gate oder eine Basis des ersten Eingangstransistors (M7) die Referenzspannung (V_{REF}) empfängt, während ein Gate oder eine Basis des zweiten Eingangstransistors (M8) die Anpassungsspannung (V_{AGC}) empfängt, dass ein Drain oder ein Kollektor des ersten Eingangstransistors (M7) mit einem ersten Transistor (M5) in Diodenschaltung eines zweiten Leitfähigkeitstyps eines Stromspiegels verbunden ist, der einen zweiten Transistor (M4) eines zweiten Leitfähigkeitstyps umfasst, der mit seinem Gate oder seiner Basis mit dem Gate oder der Basis eines ersten Transistors (M5) in Diodenschaltung verbunden ist, wobei die jeweilige Source oder der jeweilige Emitter des ersten bzw. des zweiten Transistors (M4, M5) des Stromspiegels mit einem zweiten Anschluss der Versorgungsspannungsquelle verbunden ist, und dass ein Drain oder Kollektor des zweiten Transistors (M4) des Stromspiegels mit dem Drain oder Kollektor des zweiten Eingangstransistors (M8) verbunden ist und dazu vorgesehen ist, den Abschwächungsstrom an den Repliktransistor (M2) in Diodenschaltung zu liefern.

3. Elektronische Schaltung (1) nach Anspruch 2, **dadurch gekennzeichnet, dass** das Vergleichsmittel einen Ausgangstransistor (M3) eines zweiten Leitfähigkeitstyps umfasst, der zwischen dem Drain oder Kollektor des zweiten Transistors (M4) des Stromspiegels und dem Gate oder der Basis und dem Drain oder Kollektor des Repliktransistors (M2) in Diodenschaltung angeordnet ist, wobei der Durchlasszustand des Ausgangstransistors (M3) zum Liefern des Abschwächungsstroms durch eine Polarisationsspannung (V_{BN1}) an einem Gate oder einer Basis des Ausgangstransistors (M3) gesteuert wird.

4. Elektronische Schaltung (1) nach Anspruch 1, wobei das Vergleichsmittel dazu vorgesehen ist, ein Anpassungssignal in Form eines Anpassungsstroms (I_{AGC}) und ein Referenzsignal in Form eines Referenzstroms (I_{REF}) zu vergleichen, **dadurch gekennzeichnet, dass** das Vergleichsmittel eine Referenzstromquelle umfasst, die mit einem ersten Eingang einer Versorgungsspannungsquelle verbunden ist, um einen Referenzstrom (I_{REF}) an einen ersten Transistor (M5) in Diodenschaltung eines zweiten Leitfähigkeitstyps eines Stromspiegels zu liefern, der einen zweiten Transistor (M4) eines zweiten Leitfähigkeitstyps umfasst, der mit seinem Gate oder seiner Basis mit dem Gate oder der Basis eines ersten Transistors (M5) in Diodenschaltung verbunden ist, wobei die Sources oder die Emitter des ersten und des zweiten Transistors (M4, M5) des Stromspiegels mit einem zweiten Anschluss der Versorgungsspannungsquelle verbunden sind, und dass ein Drain oder Kollektor des zweiten Transistors (M4) des Stromspiegels dazu vorgesehen ist, einen Anpassungsstrom (I_{AGC}) der automatischen Verstärkungssteuereinheit zu empfangen und den Abschwächungsstrom in Abhängigkeit von der Differenz zwischen dem Referenzstrom und dem Anpassungsstrom an den Repliktransistor (M2) in Diodenschaltung zu liefern.

5. Elektronische Schaltung (1) nach Anspruch 4, **dadurch gekennzeichnet, dass** das Vergleichsmittel einen Ausgangstransistor (M3) eines zweiten Leitfähigkeitstyps umfasst, der zwischen dem Drain oder Kollektor des zweiten Transistors (M4) des Stromspiegels und dem Gate oder der Basis und dem Drain oder Kollektor des Repliktransistors (M2) in Diodenschaltung angeordnet ist, wobei der Durchlasszustand des Ausgangstransistors (M3) zum Liefern des Abschwächungsstroms durch eine Polarisationsspannung (V_{BN1}) an einem Gate oder einer Basis des Ausgangstransistors (M3) gesteuert wird.

6. Elektronische Schaltung (1) nach einem der Ansprüche 2 bis 5, **dadurch gekennzeichnet, dass** der Abzweigungstransistor (M1), der Repliktransistor (M2) und der erste und der zweite Eingangstransistors (M7, M8) Transistoren von Typ PMOS sind, dass der erste und der zweite Transistor (M4, M5) des Stromspiegels und der Ausgangstransistor (M3) Transistoren vom Typ NMOS sind und dass die Polarisationsstromquelle (I_{P}) mit einem Anschluss (V_{DD}) mit hohem Potenzial der Versorgungsspannungsquelle verbunden ist, während der erste und der zweite Transistor (M4, M5) des Stromspiegels mit einem Anschluss (V_{SS}) mit niedrigem Potenzial der Versorgungsspannungsquelle verbunden sind.

7. Elektronische Schaltung (1) nach einem der Ansprüche 2 bis 5, **dadurch gekennzeichnet, dass** der Abzweigungstransistor (M1), der Repliktransistor (M2) und der erste und der zweite Eingangstransistor (M7, M8) Transistoren vom Typ NMOS sind, dass der erste und der zweite Transistor (M4, M5) des Stromspiegels und der Ausgangstransistor (M3) Transistoren vom Typ PMOS sind und dass die Polarisationsstromquelle (I_{P}) mit einem Anschluss (V_{SS}) mit niedrigem Potenzial der Versorgungsspannungsquelle verbunden ist, während der erste und der zweite Transistor (M4, M5) des Stromspiegels mit einem Anschluss (V_{DD}) mit hohem Potenzial der Versorgungsspannungsquelle verbunden sind.

8. Elektronische Schaltung (1) nach Anspruch 1, **dadurch gekennzeichnet, dass** die mittlere Gleichspannung (V_{CM}) über eine Spannungspufferzelle (20) an die Source oder den Emitter des Repliktransistors (M2) in Diodenschaltung geliefert wird.

9. Elektronische Schaltung (1) nach einem der Ansprüche 2 und 4, **dadurch gekennzeichnet, dass** das Vergleichsmittel einen Hysterese-Transistor (M6) eines ersten Leitfähigkeitstyps umfasst, der zu dem Repliktransistor (M2) in Diodenschaltung parallelgeschaltet ist, wobei eine Source oder ein Emitter des Hysterese-Transistors (M6) mit der Source oder dem Emitter des Repliktransistors (M2) verbunden ist, während ein Gate oder eine Basis des Hysterese-Transistors (M6) mit dem Gate oder der Basis des Repliktransistors (M2) in Diodenschaltung verbunden ist, und dass ein Drain oder Kollektor des Hysterese-Transistors (M6) mit dem Gate oder der Basis und dem Drain oder Kollektor des ersten Transistors (M5) in Diodenschaltung des Stromspiegels verbunden ist.

10. Elektronische Schaltung (1) nach Anspruch 9, **dadurch gekennzeichnet, dass** der Hysterese-Transistor (M6) wie der Repliktransistor (M2) und der Abzweigungstransistor (M1) vom Typ PMOS oder vom Typ NMOS ist.

## Claims

1. Electronic circuit (1) including, in an automatic gain control loop, an input amplifier (2), which includes two inputs arranged to receive two input signals (V_{IN}+, V_{IN}-) having a determined frequency, which has a phase shift of 180° one to the other, an automatic gain control unit (5) connected to the output of the input amplifier (2) to detect an amplitude level of an output signal (V_{OUT}) of the input amplifier, and a unit (10) for attenuating the two input signals (V_{IN}+, V_{IN}-) of the input amplifier (2) based on an adaptation signal (V_{AGC}) supplied by the automatic gain control unit (5),
**characterized in that** the attenuation unit (10) includes a means of comparison for comparing the adaptation signal (V_{AGC}) to a reference signal (V_{REF}) and for supplying an attenuation current, whose intensity is a function of the difference between the adaptation signal (V_{AGC}) and the reference signal (V_{REF}), to a diode-connected replica transistor (M2) having a first conductivity type, which is connected by a source or an emitter to a continuous mean voltage (V_{CM}), which is continuous mean voltage of the two input signals (V_{IN+}, V_{IN-}) of the input amplifier (2), the diode-connected replica transistor (M2) controlling a shunt transistor (M1) having a first conductivity type, which defines a shunt resistance connected to the input amplifier (2) input, whose resistive value depends on the intensity of the attenuation current passing through the diode-connected replica transistor (M2), and
**in that** the shunt transistor (M1) is an identical transistor to the replica transistor (M2), **in that** a source or an emitter of the shunt transistor (M1) is connected to a first input of the input amplifier (2), and **in that** a drain or a collector of the shunt transistor (M1) is connected to a second input of the input amplifier (2).

2. Electronic circuit (1) according to claim 1, wherein the means of comparison is arranged to compare an adaptation signal in the form of an adaptation voltage (V_{AGC}) and a reference signal in the form of a reference voltage (V_{REF}), **characterized in that** the means of comparison includes a pair of input transistors (M7, M8) having a first type of conductivity, each connected via a source or an emitter thereof to a polarisation current source (I_{P}), which is connected to a first terminal of a supply voltage source, a gate or base of the first input transistor (M7) receiving the reference voltage (V_{REF}), while a gate or base of the second input transistor (M8) receives the adaptation voltage (V_{AGC}), **in that** a drain or collector of the first input transistor (M7) is connected to a first diode-connected transistor (M5) having a second type of conductivity of a current mirror, which includes a second transistor (M4) having a second type of conductivity connected via a gate or base thereof to a gate or base of the first diode-connected transistor (M5), sources or emitters of the first and second transistors (M4, M5) of the current mirror being connected to a second terminal of the supply voltage source, and **in that** a drain or collector of the second transistor (M4) of the current mirror is connected to a drain or collector of the second input transistor (M8) and arranged to supply the attenuation current to the diode-connected replica transistor (M2).

3. Electronic circuit (1) according to claim 2, **characterized in that** the means of comparison includes an output transistor (M3) having a second type of conductivity, which is arranged between the drain or collector of the second transistor (M4) of the current mirror and a gate or base and a drain or collector of the diode-connected replica transistor (M2), the conduction of the output transistor (M3) for supplying the attenuation current being controlled by a polarisation voltage (V_{BN1}) across a gate or base of the output transistor (M3).

4. Electronic circuit (1) according to claim 1, wherein the means of comparison is arranged to compare an adaptation signal in the form of an adaptation current (I_{AGC}) and a reference signal in the form of a reference current (I_{REF}), **characterized in that** the means of comparison includes a reference current source, which is connected to a first terminal of a supply voltage source, to supply a reference current (I_{REF}) to a first diode-connected transistor (M5) having a second type of conductivity of a current mirror, which includes a second transistor (M4) having a second type of conductivity connected via a gate or base thereof to a gate or base of the first diode-connected transistor (M5), sources or emitters of the first and second transistors (M4, M5) of the current mirror being connected to a second terminal of the supply voltage source, and **in that** a drain or collector of the second transistor (M4) of the current mirror is arranged to receive an adaptation current (I_{AGC}) from the automatic gain control unit, and to supply the attenuation current to the diode-connected replica transistor (M2) depending on the difference between the reference current and the adaptation current.

5. Electronic circuit (1) according to claim 4, **characterized in that** the means of comparison includes an output transistor (M3) having a second type of conductivity, which is arranged between the drain or collector of the second transistor (M4) of the current mirror and a gate or base and a drain or collector of the diode-connected replica transistor (M2), the conduction of the output transistor (M3) for supplying the attenuation current being controlled by a polarisation voltage (V_{BN1}) across a gate or base of the output transistor (M3).

6. Electronic circuit (1) according to any of claims 2 to 5, **characterized in that** the shunt transistor (M1), the replica transistor (M2) and the first and second input transistors (M7, M8) are PMOS transistors, **in that** the first and second transistors (M4, M5) of the current mirror and the output transistor (M3) are NMOS transistors, **in that** the polarisation current source (I_{P}) is connected to a high potential terminal (V_{DD}) of the supply voltage source, whereas the first and second transistors (M4, M5) of the current mirror are connected to a low potential terminal (V_{SS}) of the supply voltage source.

7. Electronic circuit (1) according to any of claims 2 to 5, **characterized in that** the shunt transistor (M1), the replica transistor (M2) and the first and second input transistors (M7, M8) are NMOS transistors, **in that** the first and second transistors (M4, M5) of the current mirror and the output transistor (M3) are PMOS transistors, **in that** the polarisation current source (I_{P}) is connected to a low potential terminal (V_{SS}) of the supply voltage source, whereas the first and second transistors (M4, M5) of the current mirror are connected to a high potential terminal (V_{DD}) of the supply voltage source.

8. Electronic circuit (1) according to claim 1, **characterized in that** the continuous mean voltage (V_{CM}) is supplied to a source or emitter of the diode-connected replica transistor (M2) via a voltage buffer cell (20).

9. Electronic circuit (1) according to any of claims 2 and 4, **characterized in that** the means of comparison includes a hysteresis transistor (M6) having a first type of conductivity, which is connected in parallel to the diode-connected replica transistor (M2), a source or emitter of the hysteresis transistor (M6) being connected to a source or emitter of the replica transistor (M2), whereas a gate or base of the hysteresis transistor (M6) is connected to a gate or base of the diode-connected replica transistor (M2), and **in that** a drain or collector of the hysteresis transistor (M6) is connected to a gate or base and to a drain or collector of the first diode-connected transistor (M5) of the current mirror.

10. Electronic circuit (1) according to claim 9, **characterized in that** the hysteresis transistor (M6) is a PMOS or NMOS transistor, like the replica transistor (M2) and the shunt transistor (M1).
